Europäisches Patentamt

European Patent Office

Office européen des brevets

Numéro de publication: **0 367 680**
**A1**

# DEMANDE DE BREVET EUROPEEN

Numéro de dépôt: 89403031.1

Date de dépôt: 03.11.89

Int. Cl.5 **H01L 25/18 , H01L 23/52 , H01L 23/66**

Priorité: 04.11.88 FR 8814415

Date de publication de la demande:
**09.05.90 Bulletin 90/19**

Etats contractants désignés:
**DE GB IT NL**

Demandeur: **THOMSON-CSF**
**51, Esplanade du Général de Gaulle**
**F-92800 Puteaux(FR)**

Inventeur: **Arsene-Henry, Patrice**
**THOMSON-CSF SCPI-CEDEX 67**
**F-92045 Paris La Defense(FR)**
Inventeur: **Calligaro, Michel**
**THOMSON-CSF SCPI-CEDEX 67**
**F-92045 Paris La Defense(FR)**
Inventeur: **Du Hamel de Milly, Olivier**
**THOMSON-CSF SCPI-CEDEX 67**
**F-92045 Paris La Defense(FR)**
Inventeur: **Lacour, André**
**THOMSON-CSF SCPI-CEDEX 67**
**F-92045 Paris La Defense(FR)**

Mandataire: **Albert, Claude et al**
**THOMSON-CSF SCPI**
**F-92045 PARIS LA DEFENSE CEDEX 67(FR)**

Module semi-conducteur monolithique à diode à avalanche munie de circuits d'adaptation aux applications en hyperfréquence, et procédé de fabrication correspondant.

La conception et la réalisation, sous forme de circuit intégré de type monolithique, d'éléments à résistance négative du type des diodes IMPATT ou GUNN munis de circuits d'adaptation aux applications hyperfréquences.

Selon l'invention, le module semi-conducteur monolithique comprend une première (23) et une seconde (22) mésas déposées sur une couche fortement thermoconductrice (21), la dite première mésa (23) constituant ladite diode à résistance négative, et la seconde mésa (22) formant élément capacitif d'isolation,

et les dites mésas (23, 22) sont connectées par une lame métallique (24) en pont à air, formant inductance d'accord.

Fig. 2a

Fig. 2b

# MODULE SEMI-CONDUCTEUR MONOLITHIQUE A DIODE A AVALANCHE MUNIE DE CIRCUITS D'ADAPTATION AUX APPLICATIONS EN HYPERFREQUENCE, ET PROCEDE DE FABRICATION CORRESPONDANT

Le domaine de l'invention est celui de la génération et de l'amplification d'ondes électromagnétiques dans la bande des hyperfréquences.

L'invention concerne plus précisément la conception et la réalisation, sous forme de circuit intégré de type monolithique, d'éléments à résistance négative du type des diodes IMPATT ou GUNN munis de circuits d'adaptation aux applications hyperfréquences.

Dans leurs modes de réalisations actuelles, les diodes de type IMPATT ou GUNN présentent un certain nombre de limitations, liées à leur technologie de réalisation, et à leur impédance d'utilisation en application hyperfréquence.

Du point de vue des technologies actuelles de fabrication, les diodes IMPATT sont disponibles encapsulées dans des boîtiers céramiques dont les éléments parasites sont situés juste au niveau de la puce, sans qu'on puisse en modifier sensiblement la disposition. Ceci limite la bande de fréquence de fonctionnement, et impose un système de propagation en mode coaxial relativement encombrant.

D'autre part, l'impédance présentée par les diodes IMPATT ou GUNN est insuffisante pour permettre une adaptation directe à des lignes de propagation du type de celles mises en oeuvre en technologie microruban.

On connaît des circuits d'adaptation conçus pour élever l'impédance de sortie de diodes à avalanche.

Ainsi, le brevet US 4.673.958 (BAYRAKTAROGLU) propose un tel circuit d'adaptation. La solution proposée fait apparaître au circuit de charge la résistance négative intrinsèque de la diode, de valeur très faible. Or, la structure électrique du circuit ne permet pas de séparer suffisamment la zone de fréquence où l'on lutte contre les phénomènes parasites de la zone de fréquence où l'on exploite les propriétés de résistance négative de la diode.

En outre, cette solution antérieure implique l'implantation de couches diélectriques.

L'invention a pour objet de pallier ces différents inconvénients.

Plus précisément, un premier objectif de l'invention est de fournir un composant à diode à avalanche dont l'amplitude du terme réel de l'impédance présentée à une charge d'hyperfréquence soit plus élevée que pour une diode à avalanche seule.

Un autre objectif de l'invention est de fournir un tel composant qui soit directement utilisable en technologie microruban.

Un objectif complémentaire est de réaliser un tel composant qui, par rapport aux composants existants compatibles à la technologie coaxiale ou guidée, apporte les avantages suivants :
- une diminution du poids et du volume,
- une amélioration du rendement électrique par la diminution des longueurs de la ligne de propagation,
- une augmentation de la bande passante par le contrôle de la disposition et de la valeur des éléments localisés autour de la puce.

L'invention a également pour objectif d'intégrer les circuits d'adaptation aux composants, ce qui permet notamment d'exploiter des principes d'association de modules du même type à plus large bande. On étend ainsi le champ d'application des éléments à résistance négative aux émetteurs de radar agile et aux amplificateurs de télécommunications.

Ces objectifs, ainsi que d'autres qui apparaîtront par la suite, sont atteints à l'aide d'un circuit électronique notamment destiné à la génération et/ou à l'amplification d'ondes électromagnétiques dans la gamme des hyperfréquences, du type constitué d'un élément à résistance négative tel qu'une diode IMPATT ou GUNN, sur laquelle est branchée en parallèle une inductance d'accord isolée de la masse par une capacité,
circuit caractérisé en ce qu'il est réalisé sous forme d'un module semi-conducteur monolithique comprenant une première et une seconde mésas déposées sur une couche fortement thermoconductrice, ladite première mésa constituant ladite diode à résistance négative, et la seconde mésa formant ledit élément capacitif d'isolation,
et en ce que lesdites mésas sont connectées par une lame métallique en pont à air, formant ladite inductance d'accord.

Dans une première version de l'invention, ladite mésa formant élément capacitif est constituée par une couche de diélectrique déposée entre deux couches métalliques.

Dans une seconde version de l'invention, ladite mésa formant élément capacitif est constituée par une diode Schottky, destinée à être polarisée en inverse. Selon un mode de réalisation particulier de l'invention, ledit module monolithique comporte des moyens d'adaptation à son impédance d'utilisation constitués par une troisième mésa formant capacité d'adaptation, et reliée à ladite première mésa par une lame métallique en pont à air formant inductance d'adaptation.

Avantageusement, ladite troisième mésa est sensiblement de même structure que ladite seconde mésa.

L'invention a également pour objet un procédé de fabrication d'un tel circuit caractérisé en ce qu'il comprend les étapes suivantes :
- on réalise une épitaxie sur substrat semi-conducteur, de façon à faire apparaître au moins une zone d'avalanche, une zone de transit, et une couche tampon :
- on effectue une photogravure localisée du substrat à l'emplacement de ladite seconde mésa ;
- on dépose ladite couche thermoconductrice au contact de ladite zone d'avalanche après métallisation ;
- on grave lesdites première et seconde mésas dans ledit substrat, et on dépose leurs couches constitutives complémentaires ;
- on dépose ledit pont métallique formant inductance d'accord, après résinage épais du module, et ouverture de contacts au niveau desdites mésas.

Dans le cas de la première version du circuit, ladite étape de photogravure localisée du substrat consiste à graver localement les zones d'avalanche et de transit dudit substrat, et ladite opération de dépôt des couches constitutives de la seconde mésa consiste à déposer un matériau diélectrique du type $Si_3N_4$.

Dans la seconde version, ladite étape de photogravure localisée du substrat consiste à graver localement la zone d'avalanche dudit substrat, et ladite opération de dépôt des couches constitutives de la seconde mésa consiste à déposer un contact ohmique localisé du type Au Ge Ni Ti Pt Au.

Préférentiellement, le matériau semi-conducteur constitutif du substrat est l'arseniure du gallium.

D'autres caractéristiques et avantages de l'invention apparaîtront à la lecture de la description suivante de modes préférentiels de réalisation et d'utilisation de l'invention, donnés à titre illustratif et non limitatif, et des dessins annexés dans lesquels :
- la figure 1 schématise le circuit électronique mis en oeuvre sous forme du module semi-conducteur monolithique de l'invention ;
- les figures 2a, 2b représentent la vue de côté, et de dessus respectivement du module selon l'invention dans une première version ;
- la figure 3 représente le profil de dopage du substrat semi-conducteur du module suivant l'invention, après épitaxie ;
- la figure 4 schématise les différentes étapes technologiques a à 1 de fabrication de la version du module de l'invention des figures 2a, 2b ;
- les figures 5a, 5b représentent la vue de côté, et de dessus respectivement du module selon l'invention dans la seconde version ;
- la figure 6 schématise les différentes étapes technologiques a à g de fabrication de la version du module de l'invention des figures 5a, 5b ;
- la figure 7 illustre le circuit d'un module monolithique suivant l'invention à éléments d'adaptation intégrée ;
- les figures 8a, 8b schématisent la structure d'un module suivant l'invention, mettant en oeuvre le circuit intégré schématisé en figure 7, dans le mode de réalisation de la seconde version à diode Schottky ;
- la figure 9 schématise une vue de dessus d'un circuit d'association de quatre modules préadaptés selon l'invention.

Le mode de réalisation décrit consiste à intégrer des moyens d'adaptation à une diode à avalanche du type AsGa, sous forme d'un module semi-conducteur.

Les propriétés électriques du circuit associé à la diode doivent, pour tirer le maximum de puissance de la diode à la fréquence désirée, satisfaire les critères suivants :
- l'impédance complexe du circuit est telle que la partie imaginaire soit opposée à celle de la diode à la fréquence de travail et que la partie réelle de l'impédance du circuit soit opposée à la résistance négative de la diode à l'optimum de sa puissance.
- la variation de l'impédance complexe du circuit en fonction de la fréquence (F $\epsilon$ [0, Fo/2] ; Fo = fréquence de travail) doit satisfaire les critères de M. HINES (Proceeding IEEE Déc. 1972 - p. 1540), M. BRACKETT (BSTJ 52 N° 3 Mars 1973 - p 27-36) pour éviter les phénomènes paramétriques et les oscillations basse fréquence.
- la variation de l'impédance complexe du circuit en fonction de la fréquence (F $\epsilon$ [Fa, Fc] ; Fa = fréquence d'avalanche, Fc = fréquence de coupure) ne doit pas présenter de boucles pour que l'effet de la température ne provoque pas de sauts de fréquence.

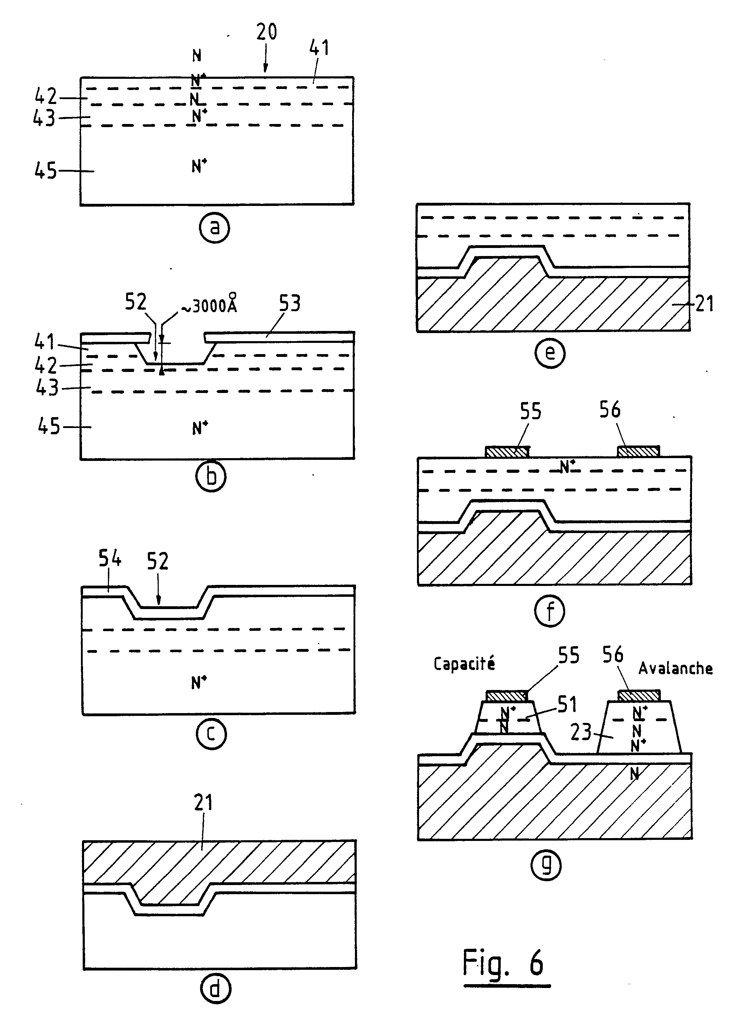

Le schéma de principe électrique du circuit choisi, proposé par M. HINES (Proceeding IEEEE vol. 60 Déc. 1972-p. 1544 fig. 6a) a des propriétés intéressantes sur deux points : il présente des variations, qui dans les zones [0 ; Fo/2] et [Fa ; Fc] sont indépendantes les unes des autres rendant plus aisée l'optimisation du circuit. Il augmente, par un effet de transformateur, le terme réel négatif vu par le circuit de charge à Fo.

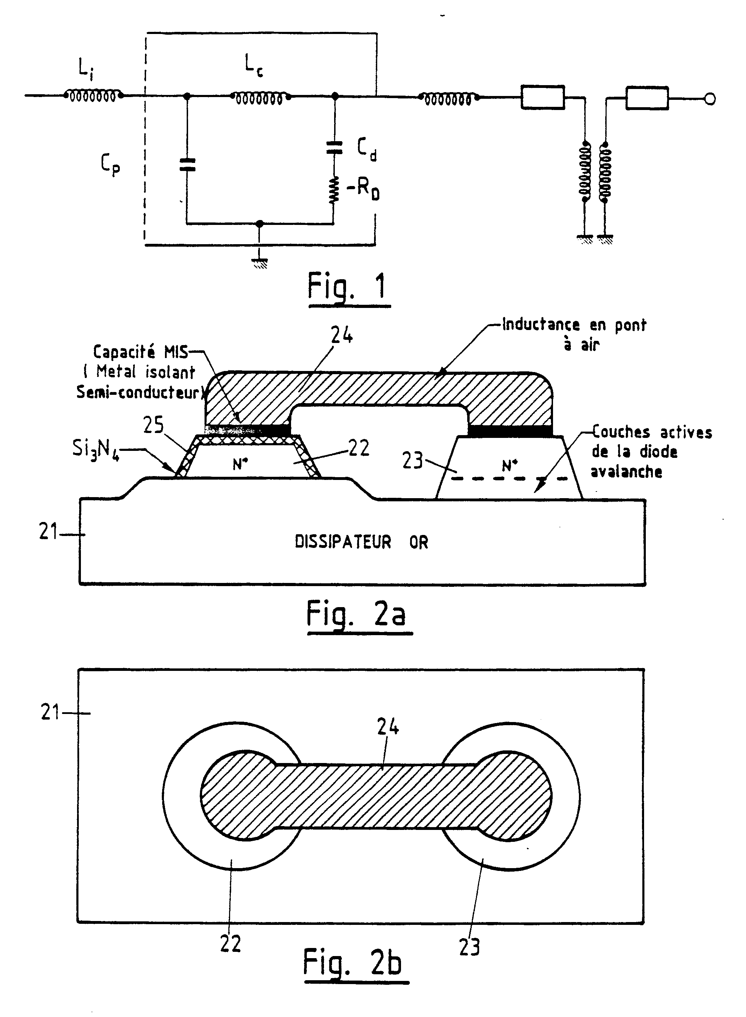

Cette solution, représentée sur la figure 1, consiste à mettre en parallèle sur la diode IMPATT une inductance d'accord Lc qui est isolée par rapport à la masse par une capacité Cp. L'inductance est calculée pour que la résonance avec la capacité dynamique Cd de la diode soit à Fo. On bénéficie alors d'un effet de transformateur élévateur de la résistance négative intrinsèque de la diode.

C'est ce circuit qui est destiné à être intégré sous forme monolithique dans les deux versions de base de l'invention.

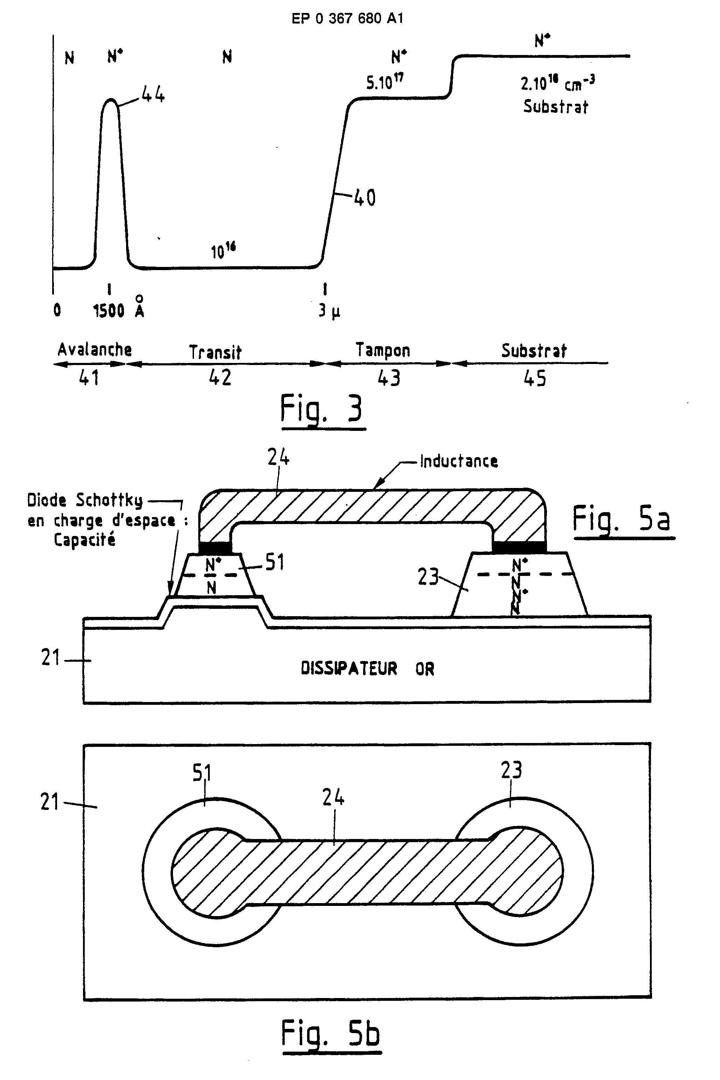

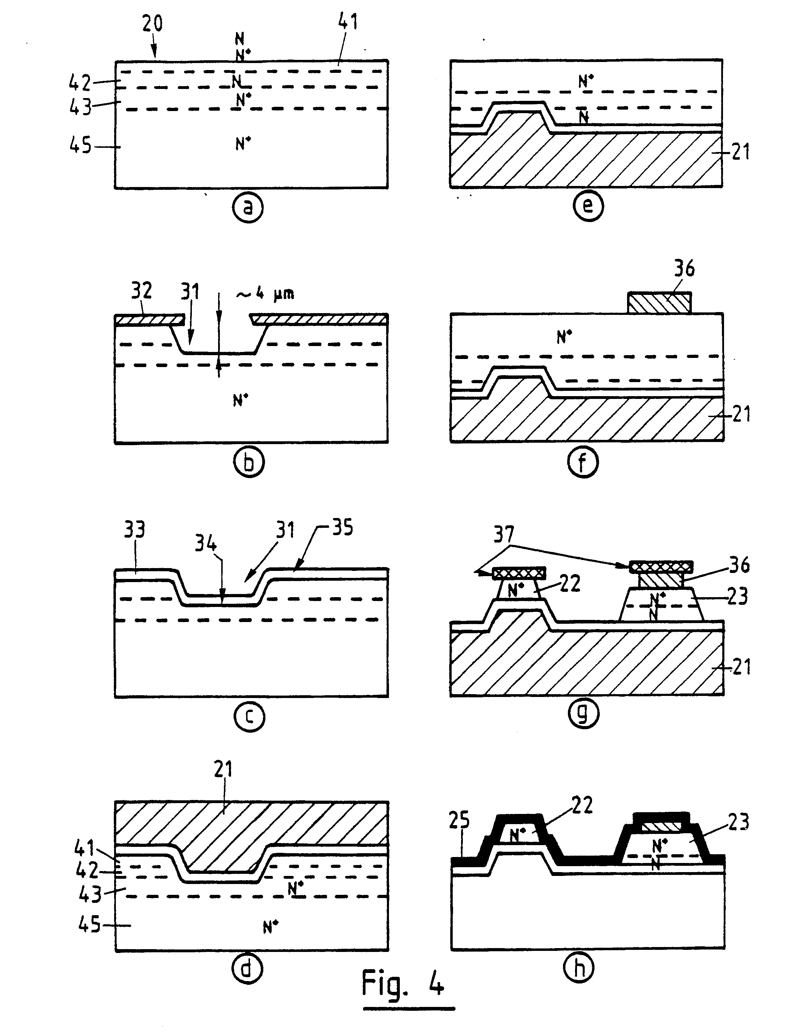

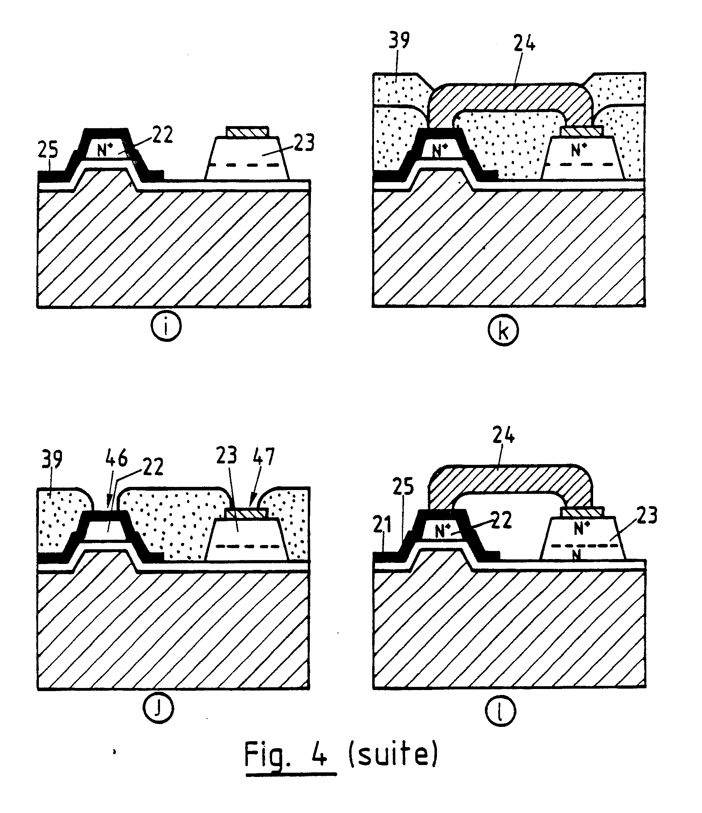

Une première version consiste à réaliser la capacité Cp d'isolation sous forme d'un condensateur à diélectrique (Fig. 2 et 4). La seconde version utilise pour Cp une diode Schottky (Fig 5 et 6).

Les procédés de fabrication du module à diode IMPATT monolithique selon l'invention évoluent légèrement en fonction des deux structures proposées.

1ère structure proposée : version à condensateur.

Comme on peut le voir en figures 2a, 2b, le module de cette première version est constitué par 2 mésas 22, 23 déposées sur un dissipateur de chaleur 21. Les deux mésas 22, 23 correspondent respectivement à une capacité MIS (Metal Isolant Semi-conducteur), et à une diode à avalanche. Les deux mésas 22, 23 sont connectées l'une à l'autre par une inductance en pont à air 24.

Les couches N et $N^+$ des mésas 22, 23 proviennent d'un substrat semi-conducteur, du type du Ga AS ayant subi une opération d'épitaxie.

L'épitaxie réalisée sur substrat $N^+$ a le profil de dopage 40 vu sur la figure 3.

On peut diviser les couches épitaxiées en trois zones :
- zone d'avalanche (41), comprenant un pic de dopage 44 situé à environ $0,15 \ 10^{-6}$ m de profondeur,
- zone de transit (42),
- couche tampon (43) dont la frontière avec la zone de transit est située à une profondeur d'environ $3.10^{-6}$ m.

La technologie consiste à réaliser une épaisse couche d'or 21 en contact thermique direct avec les zones actives de la diode avalanche 23 afin d'évacuer la chaleur. Parallèlement à cette diode 23 on réalise une autre mésa ne comprenant qu'une couche $N^+$ sur laquelle on dépose une couche de nitrure de silicium ($Si_3N_4$) qui va servir de diélectrique pour la capacité dont les 2 électrodes sont le $N^+$ 43 et un dépôt métallique supérieur. Les étapes technologiques sont détaillées en figure 4 :

a) Epitaxie, pour définir les 3 zones 41, 42, 43 dans le substrat 20 ;

b) Photogravure localisée 31 des zones d'avalanche et de transit sur une profondeur d'environ $4 \ 10^{-6}$ m. La résine photosensible 32 est ensuite dissoute ;

c) Métallisation. Platine Titane Platine Or. La couche 33 déposée forme un contact ohmique 34 au niveau de la cavité 31, et un contact Schottky ailleurs ;

d) Croissance électrolytique du dissipateur or 21, sur $40 \ 10^{-6}$ m environ ;

e) Amincissement du substrat jusqu'à une épaisseur d'environ $20 \ 10-6$ m.

f) Dépôt localisé par lift off du contact ohmique 36 de la diode avalanche Au Ge Ni Ti Pt Au ;

g) Photolitographie et gravure des mésas des capacités 22 et diode avalanche 23, puis élimination des dépôts de résine 37

h) Dépôt du $Si_3N_4$ 25 destiné à former le diélectrique du condensateur 22 ;

i) Ouverture de la couche 25 de $Si_3N_4$, de façon à dégager la mésa 23 ;

j) Résinage épais 39 et ouverture de contacts 46, 47 sur le sommet des mésas 22, 23 ;

k) Dépôt localisé d'un ruban d'or 24 constituant l'inductance d'accord ;

l) Dissolution de la résine 39, puis séparation, par découpe, des puces.

2ème structure proposée : version à diode Schottky.

Comme on peut le voir en figure 5 cette seconde version diffère de la structure de la figure 2 en ce que la capacité MIS est remplacée par une diode Schottky en charge d'espace, formant capacité. Cette diode Schottky est constituée par la mésa 51.

Les étapes technologiques de fabrication sont avantageusement les suivantes (Fig. 6) :

a) Epitaxie de la même manière que sur la figure 4a ;

b) Photogravure localisée 52 de la zone d'avalanche 41 sur environ $0,3 \ 10^{-6}$ m, puis élimination de la couche de résine 53.

c) Métallisation. Platine Titane Platine Or. La couche 54 déposée forme un contact Schottky sur l'ensemble de la surface du substrat épitaxié ;

d) Croissance électrolytique du dissipateur Or 21, sur $40 \ 10^{-6}$ m environ ;

e) Amincissement du substrat jusqu'à une épaisseur d'environ $20 \ 10^{-6}$ m ;

f) Dépôt localisé par lift off du contact ohmique 56 de la diode avalanche et du contact ohmique 55 de la capacité (Au Ge Ni Ti Pt Au) ;

g) Gravure des mésas des capacités 51 et diode avalanche 23.

Les étapes suivantes de résinage, dépôt d'inductance, dissolution de résine, et séparation, par découpe, des puces sont identiques à celles représentées et commentées en j, k, l de la figure 4.

Par les mêmes procédés que décrits précédemment, on peut réaliser sous forme monolithique un module incluant des moyens d'adaptation directe à l'impédance d'utilisation.

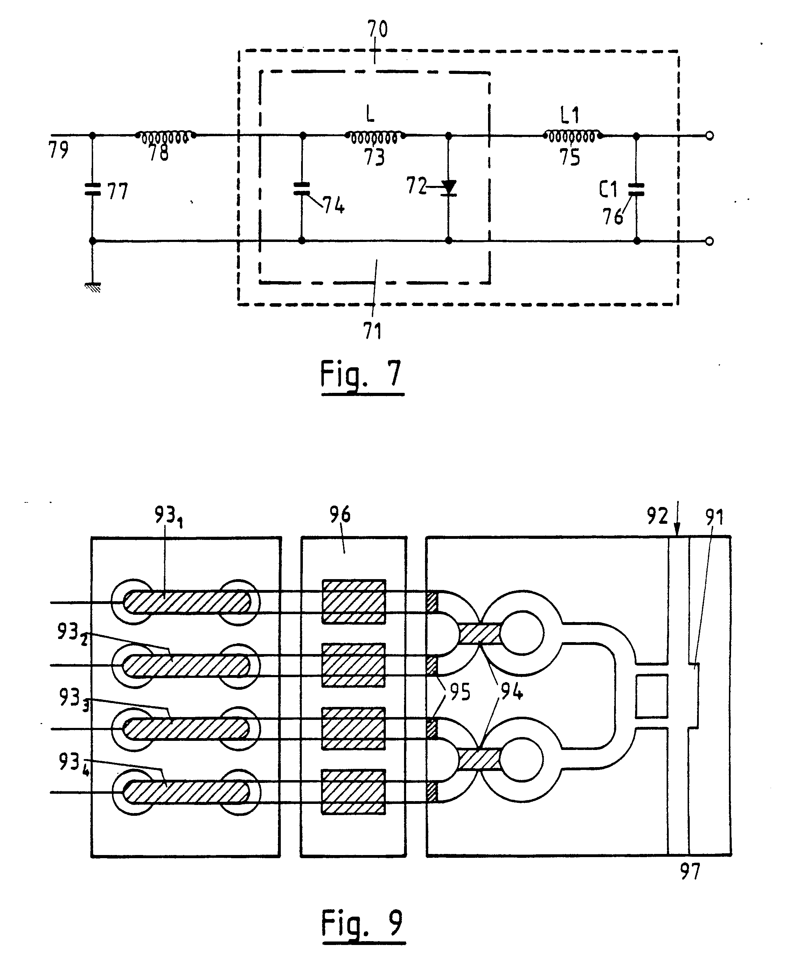

Le schéma de principe de ce mode de réalisation est présenté en figure 7.

Le module 70 comporte le sous-module 71 avec diode à avalanche 72, inductance d'accord 73 et capacité d'isolation 74, comme décrit précédemment.

Il inclut en outre deux éléments d'adaptation 75, 76, correspondant respectivement à une inductance d'adaptation 75, et à une capacité d'adaptation 76.

L'ensemble de ces composants 72, 73, 74, 75, 76 sont intégrés sur le même module monolithique.

Les éléments de découplage BF 77, 78, ont été représentés pour illustrer un mode d'utilisation, avec polarisation 79.

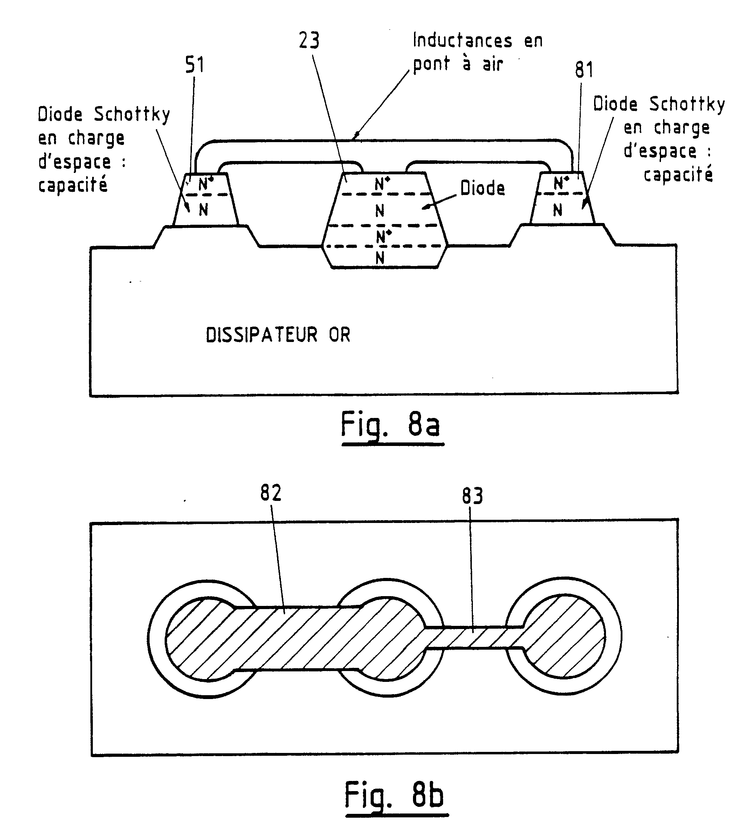

Les figures 8a et 8b représentent un exemple de réalisation d'un tel module en vue de côté (figure 8a) et en vue de dessus (figure 8b).

Le module est constitué d'une mésa principale 23 formant la diode à avalanche, connectée par deux inductances en pont à air 82, 83 à deux mésas latérales 51, 81, sensiblement symétriques. Chacune de ces mésas latérales 51, 81 correspond à une diode Schottky en charge d'espace, jouant le rôle des capacités 74 et 76.

La technologie de fabrication d'un tel module dérive directement du procédé de la figure 6.

Une structure équivalente pourrait être réalisée conformément à la première version présentée (version à condensateur), dans laquelle les deux mésas latérales formeraient chacune une capacité MIS.

Les applications industrielles dans le domaine des émetteurs de Radar, se situent au niveau des puissances moyennes émises entre 10 Watt et plusieurs centaines de Watt pour des puissances crêtes de l'ordre de 40 Watt jusqu'à plusieurs kW. Ces niveaux de puissance peuvent être atteints en associant des modules monolithiques préadaptés ou adaptés. L'intérêt de l'invention est que les circuits d'association, qui peuvent prendre des formes très variées, sont réalisables en technologie microstrip sur céramique, ce qui réduit fortement les volumes par rapport aux technologies coaxiale ou guidée. A titre indicatif, la figure 9 représente un circuit d'association de 4 modules préadaptés.

Les circuits d'association sont composés d'un coupleur 3dB 91 et de deux tés Wilkinson. Le signal qui arrive de la porte "entrée" 92 est réparti également en amplitude au niveau de chaque module $93_1$, $93_2$, $93_3$, $93_4$. Des charges d'équilibre 94 et des capacités série 95 sont disposées aux branchements. Les modules 93 sont associés à travers un jeu d'interfaces d'adaptation 96. Bien entendu, il est possible d'utiliser des modules adaptés du type de ceux de la figure 8 à la place des modules préadaptés 93, ce qui évite d'utiliser les interfaces 96.

Si les modules sont auto-oscillants, le signal synchronise les modules sur une même fréquence et le signal synchronisé est recueilli sur la porte "sortie" 97, compte tenu des propriétés bien connues des tés Wilkinson et du coupleur 3 dB.

Si les modules se comportent comme des résistances négatives stables, le signal incident se réfléchit avec amplification au niveau des modules et le signal amplifié est recueilli sur la porte "sortie" 93. Les niveaux de puissance atteints sont de (15 W moyen, 60 W crête) en bande I, (10 W moyen, 40 W crête) en bande J.

Le module adapté ou préadapté monolithique peut être également utilisé dans les amplificateurs en transmission décrit dans le brevet français n° 77.20657 en utilisant la propagation sur microstrip sur céramique.

**Revendications**

1. Circuit électronique notamment destiné à la génération et/ou à l'amplification d'ondes électromagnétiques dans la gamme des hyperfréquences, du type constitué d'un élément à résistance négative telle qu'une diode IMPATT ou GUNN, sur laquelle est branchée en parallèle une inductance d'accord isolée de la masse par une capacité, la diode étant réalisée sur une couche fortement thermo-conductrice (21), circuit caractérisé en ce qu'il est réalisé sous forme d'un module semi-conducteur monolithique comprenant une première (23) et une seconde (22, 51) mésas déposées sur la couche fortement thermo-conductrice (21), ladite première mésa (23) constituant ladite diode à résistance négative, et la seconde mésa (22, 51) formant ledit élément capacitif d'isolation, et en ce que lesdites mésas (23, 22, 51) sont connectées par une lame métallique (24) en pont à air, formant ladite inductance d'accord.

2. Circuit selon la revendication 1 caractérisé en ce que le matériau constitutif de ladite couche fortement thermo-conductrice (21) et/ou de ladite lame métallique (24) formant pont à air est l'or.

3. Circuit selon la revendication 1 caractérisé en ce que ladite mésa (22) formant élément capacitif est constituée par une couche de diélectrique (25) déposée entre deux couches métalliques (22, 24).

4. Circuit selon la revendication 1 caractérisé en ce que ladite mésa (51) formant élément capacitif est constituée par une diode Schottky, destinée à être polarisée en inverse.

5. Circuit électronique selon l'une quelconque des revendications 1 à 4 caractérisé en ce que ledit module monolithique comporte des moyens d'adaptation à son impédance d'utilisation constitués par une troisième mésa (81) formant capacité d'adaptation, et reliée à ladite première mésa (23) par une lame métallique (83) en pont à air formant inductance d'adaptation.

6. Circuit selon la revendication 5 caractérisé en ce que ladite troisième mésa (81) est sensiblement de même structure que ladite seconde mésa (51).

7. Procédé de fabrication d'un circuit selon l'une quelconque des revendications 1 à 6 caractérisé en ce qu'il comprend les étapes suivantes :
- on réalise une épitaxie sur substrat semi-conducteur (20), de façon à faire apparaître au moins une zone d'avalanche (41), une zone de transit (42), et une couche tampon (43) ;
- on effectue une photogravure localisée du substrat à l'emplacement de ladite seconde mésa (22, 51) ;
- on dépose ladite couche thermoconductrice (21) au contact de ladite zone d'avalanche (41) après métallisation (33, 54) ;
- on grave lesdites première (23) et seconde (22, 51) mésas dans ledit substrat (20), et on dépose leurs couches constitutives complémentaires ;
- on dépose ledit pont métallique (24) formant inductance d'accord, après résinage épais du module, et ouverture de contact au niveau desdites mésas (22, 23, 51).

8. Procédé selon la revendication 7 pour la fabrication d'un circuit selon la revendication 3 caractérisé en ce que ladite étape de photogravure localisée du substrat (20) consiste à graver localement les zones d'avalanche (41) et de transit (42) dudit substrat, et en ce que ladite opération de dépôt des couches consitutives de la seconde mésa (22) consiste à déposer un matériau diélectrique (25) du type $Si_3N_4$.

9. Procédé selon la revendication 7 pour la fabrication d'un circuit selon la revendication 4 caractérisé en ce que ladite étape de photogravure localisée du substrat (20) consiste à graver localement la zone d'avalanche (41) dudit substrat, et en ce que ladite opération de dépôt des couches constitutives de la seconde mésa consiste à déposer un contact ohmique localisé (55) du type Au Ge Ni Ti Pt Au.

10. Procédé selon la revendication 7 caractérisé en ce que ladite métallisation préalable au dépôt de la couche thermoconductrice (21) consiste à effectuer un dépôt platine, titane, platine or.

11. Procédé selon la revendication 7 caractérisé en ce que ledit dépôt de la couche thermoconductrice (21) est effectué par croissance électrolytique.

12. Procédé selon la revendication 7 caractérisé en ce qu'on effectue un dépôt localisé, par "lift off" du contact ohmique (36, 56) de la diode avalanche, préablement à la photogravure de la première mésa (23), les couches déposées étant Au Ge Ni Ti Pt Au.

13. Procédé selon l'une quelconque des revendications 7 à 12 caractérisé en ce que ledit substrat semi-conducteur (20) est l'arséniure de gallium.

14. Procédé selon la revendication 7 caractérisé en ce que ladite opération d'épitaxie est réalisée de façon que le pic de dopage (44) de la zone d'avalanche (41) soit situé à une profondeur d'environ 0,15 $10^{-6}$ m, et que la frontière entre la zone de transist (42) et la couche tampon (43) soit située à une profondeur d'environ 3 $10^{-6}$ m.

15. Procédé selon la revendication 7 caractérisé en ce que ledit substrat est aminci à une épaisseur d'environ 20 $10^{-6}$ m avant gravure des mésas.

16. Procédé selon la revendication 7 caractérisé en ce que l'épaisseur de ladite couche de matériau thermoconducteur est d'environ 40 $10^{-6}$ m.

## Fig. 1

Capacité MIS
( Metal isolant
Semi-conducteur)

24

Inductance en pont
à air

25

Si$_3$N$_4$

N$^+$

22

23

N$^+$

Couches actives
de la diode
avalanche

21

DISSIPATEUR OR

## Fig. 2a

21

24

22

23

## Fig. 2b

Fig. 3

Diode Schottky
en charge d'espace :
Capacité

Inductance

Fig. 5a

DISSIPATEUR OR

Fig. 5b

Fig. 4

Fig. 4 (suite)

**Fig. 6**

## Fig. 7

## Fig. 9

51    23    Inductances en
pont à air    81

Diode Schottky
en charge
d'espace :
capacité

Diode Schottky
en charge
d'espace :
capacité

N⁺
N

N⁺
N
N⁺
N

Diode

N⁺
N

DISSIPATEUR OR

## Fig. 8a

82    83

## Fig. 8b

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| D,Y | US-A-4 673 958 (TEXAS) <br> * Figures 7,8b,9b; revendications 1,7,8; colonne 9, lignes 51-68 * | 1 | H 01 L 25/18 <br> H 01 L 23/52 <br> H 01 L 23/66 |
| A | | 2,3,7-9 ,13 | |
| Y | PROCEEDINGS OF THE GALLIUM ARSENIDE INTEGRATED CIRCUIT SYMPOSIUM, New Orleans, 9-11 novembre 1982, pages 25-28, IEEE, New York, US; G.D. McCORMACK et al.: "A GaAs MSI 8-bit multiplexer and demultiplexer" <br> * Page 25, no. II; page 26, figure 2 * | 1 | |
| A | IDEM | 4,8,9, 13 | |
| A | EP-A-0 143 887 (TEXAS) | | |
| A | US-A-4 436 766 (US SECRETARY OF THE NAVY) | | TECHNICAL FIELDS SEARCHED (Int. Cl.5) |
| A | DE-A-2 001 468 (PHILIPS) | | H 01 L |
| A | EP-A-0 222 203 (BBC) | | |

The present search report has been drawn up for all claims

| Place of search | Date of completion of the search | Examiner |
|---|---|---|
| THE HAGUE | 15-01-1990 | DE RAEVE R.A.L. |

EPO FORM 1503 03.82 (P0401)